# EUROPEAN PATENT APPLICATION

(11) **EP 3 901 637 A1**
(43) Date of publication of application: **27.10.2021**
(21) Application number: 19901202.2
(22) Date of filing: 04.12.2019
(51) Int. Cl.: G01R 1/06, G01R 1/067, G01R 31/50, G01R 31/28

(54) **INSPECTION JIG SUPPORT, SUPPORT, AND INSPECTION JIG**

(30) Priority: 21.12.2018 JP 2018240056
(71) Applicant: YOKOWO CO., LTD., Kita-ku Tokyo 114-8515 (JP)
(72) Inventor: MIURA Chikara, Tokyo 114-8515 (JP)
(74) Representative: Gunzelmann, Rainer
(86) International application number: PCT/JP2019/047420
(87) International publication number: WO 2020/129646

(57) **Abstract**

An inspection jig support tool includes a coupling axis portion having an axis-side fitting portion and being coupled with an inspection head body, an annular coil spring being arranged in an outer periphery of the axis-side fitting portion, and a base portion retaining the coupling axis portion such that the coupling axis portion is capable of being displaced in a radial direction of an axis and in an axial rotation direction. The base portion has a spring retaining portion retaining the annular coil spring while tolerating deformation of the annular coil spring in a radius enlarging direction and a hole-side fitting portion being fitted on the axis-side fitting portion with a gap.

## Description

### Technical Field

The present invention relates to an inspection jig support tool and so forth.

### Background Art

An electronic circuit substrate is installed in an electronic apparatus, and a connection terminal referred to as connector is installed in the substrate for connection with another substrate, an external apparatus, or the like. As one of inspection procedures in a manufacturing process of an electronic apparatus, there is a procedure in which a connector inspection jig of an inspection device is connected with the connector and an inspection is conducted.

For example, Patent Literature 1 discloses a technique of a connector inspection jig that improves visibility in performing work for position alignment between a connector including probes on an inspected side and a connector on a jig side and that has few components to be expendables. Patent Literature 2 discloses a connector inspection jig that facilitates connection work. Patent Literature 3 discloses a compliance mechanism that facilitates position alignment between a connector on an inspected side and a probe holder.

### Prior Art Documents

### Patent Literature

Patent Literature 1: JP-A-2004-273192
Patent Literature 2: JP-A-2005-283218
Patent Literature 3: JP-A-7-111176

### Summary of Invention

### Problems to be Solved by the Invention

In inspecting a substrate, the substrate is fixed to a predetermined position in a predetermined posture. However, viewing the position of each electrode of a connector mounted on the substrate, in an inspection, each electrode is not necessarily fixed to strictly the same position. Consequently, an inspection device is desired to have high tolerance for position deviation.

The number of electrodes of a connector and arrangement intervals have been adapted to achieve finer features to meet a demand for size reduction of an electronic apparatus. Thus, in inspecting the substrate, highly precise position alignment between a connector on an inspected side and an inspection jig is requested. In addition, because it is desired to shorten a time needed for an inspection, shortening of a time for connection of the inspection jig towards the connector is requested. Consequently, high responsiveness to position deviation is desired while high tolerance for position deviation is realized.

Although a technique of Patent Literature 1 can improve visibility in position alignment, Patent Literature 1 does not disclose a technique for improving precision of mechanical position alignment itself. Patent Literature 2 does not disclose a technique for improving precision of mechanical position alignment itself either.

A compliance mechanism disclosed in Patent Literature 3 can realize a certain degree of tolerance for position deviation. However, high responsiveness to position deviation cannot be realized. Although a compliance mechanism as disclosed in Patent Literature 3 tolerates position deviation in two orthogonal directions, neither tolerance nor responsiveness can be considered to be sufficient about position deviation in a direction oblique to both of the two directions. For a reason of a structure of the compliance mechanism, for example, a probe holder that can be considered to be an inspection head may slightly be inclined towards a connector on an inspected side. When the probe holder is inclined, probes obliquely contact with electrodes of the connector on the inspected side, and a lateral load acts on the probes. As a result, a problem possibly occurs that the lives of the probes are shortened.

One example of objects of the invention is to improve tolerance for and responsiveness to position deviation between a contacted side and a contacting side in a contact.

### Solution to the Problems

A first aspect of the invention provides an inspection jig support tool including: a coupling axis portion having an axis-side fitting portion and being coupled with an inspection head body; an annular coil spring being arranged in an outer periphery of the axis-side fitting portion; and a base portion retaining the coupling axis portion such that the coupling axis portion is capable of being displaced in a radial direction of an axis and in an axial rotation direction, in which the base portion has: a spring retaining portion retaining the annular coil spring while tolerating deformation of the annular coil spring in a radius enlarging direction; and a hole-side fitting portion being fitted on the axis-side fitting portion with a gap.

A second aspect provides a support tool including a first inspection jig support tool and a second inspection jig support tool according to the first aspect, in which the first inspection jig support tool and the second inspection jig support tool are arranged while the coupling axis portion of the first inspection jig support tool and the coupling axis portion of the second inspection jig support tool are in parallel with each other and the first inspection jig support tool and the second inspection jig support tool support the inspection head body such that the inspection head body is capable of being displaced in a predetermined range.

A third aspect provides an inspection jig including: the inspection head body; and the support tool according to the second aspect that supports the inspection head body.

A fourth aspect provides an inspection jig including: the inspection head body; and the support tool according to the second aspect that supports the inspection head body, in which in the inspection head body, plural probes to contact with an inspected object protrude on an inspection surface side, electrical wires of the probes are drawn out from a back surface on an opposite side to the inspection surface, and the jig base supports the inspection head body in a central portion.

A fifth aspect provides a support tool including a first inspection jig support tool and a second inspection jig support tool according to the first aspect, in which the base portion of the first inspection jig support tool is coupled with the coupling axis portion of the second inspection jig support tool.

### Advantageous Effects of Invention

In aspects of the invention, a coupling axis portion coupled with an inspection head body is retained such that displacement in a radial direction of an axis and in an axial rotation direction towards a base portion is possible. Furthermore, as for the coupling axis portion, an axis-side fitting portion is fitted in a hole-side fitting portion with a gap. Consequently, even when mounting positions of connectors on an inspected side are non-uniform, the coupling axis portion is displaced in the radial direction of the axis and in the axial rotation direction towards the base portion, and the inspection head body can thereby quickly move to an appropriate connection position for the connector on the inspected side. Thus, tolerance for and responsiveness to position deviation are excellent.

### Brief Description of Drawings

FIG. 1 is a perspective external appearance view illustrating a configuration example of a connector inspection jig in a first embodiment.
FIG. 2 is a perspective external appearance view illustrating the configuration example of the connector inspection jig in the first embodiment.
FIG. 3 is an exploded view of the connector inspection jig in the first embodiment.
FIG. 4 is a perspective external appearance view illustrating a configuration example of an inspection jig support tool in the first embodiment.
FIG. 5 is a perspective external appearance view illustrating the configuration example of the inspection jig support tool in the first embodiment.
FIG. 6 is an exploded view of the inspection jig support tool in the first embodiment.
FIG. 7 is a vertical cross-sectional view of the inspection jig support tool in the first embodiment.
FIG. 8 is a vertical cross-sectional view of a coupling axis portion in the first embodiment.
FIG. 9 is a vertical cross-sectional view of a base portion in the first embodiment.
FIG. 10 is a diagram for explaining an action implemented by the inspection jig support tool.
FIG. 11 is a diagram for explaining the action implemented by the inspection jig support tool.
FIG. 12 is a diagram for explaining tolerance for deviation of an inspection head body in an axial rotation direction, the tolerance being realized by two inspection jig support tools.
FIG. 13 is a perspective external appearance view illustrating a configuration example of a connector inspection jig in a second embodiment.
FIG. 14 is a perspective external appearance view illustrating the configuration example of the connector inspection jig in the second embodiment.
FIG. 15 is an exploded view of an inspection jig support tool in the second embodiment.
FIG. 16 is an exploded view of a connector inspection jig in a third embodiment.
FIG. 17 is a perspective external appearance view illustrating a configuration example of an inspection jig support tool in the third embodiment.
FIG. 18 is a perspective external appearance view illustrating the configuration example of the inspection jig support tool in the third embodiment.

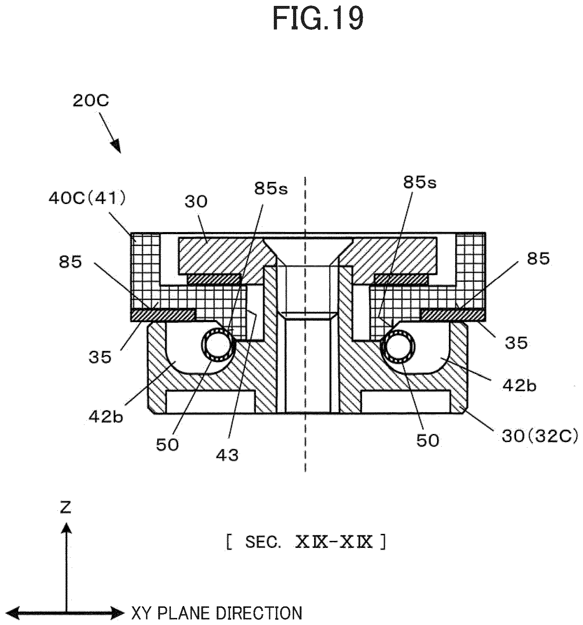

FIG. 19 is a vertical cross-sectional view of the inspection jig support tool in the third embodiment.
FIG. 20 is a perspective external appearance view illustrating a modification example of an inspection jig support tool.
FIG. 21 is a vertical cross-sectional view illustrating the modification example of an inspection jig support tool.

### Description of Embodiments

Examples of embodiments will be described; however, forms to which the invention is applicable are not limited to the following embodiments.

### First Embodiment

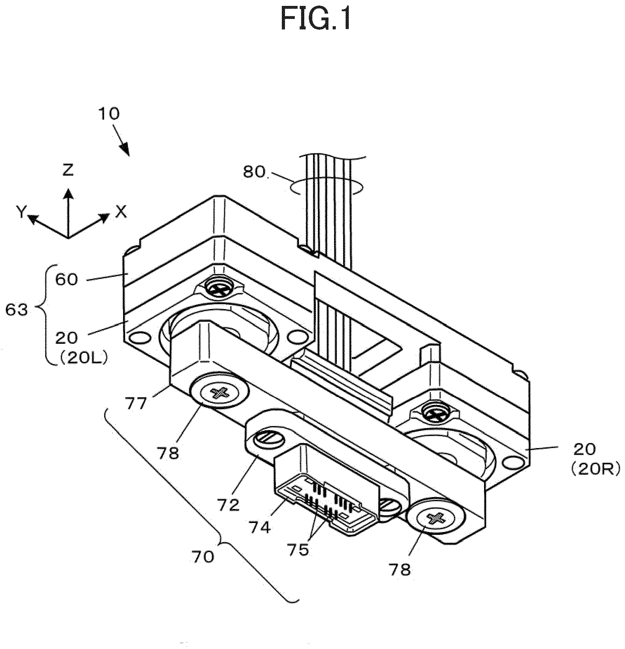

FIG. 1 is a perspective external appearance view illustrating a configuration example of a connector inspection jig 10 in a first embodiment and is an external appearance view as viewed up from an obliquely lower side.

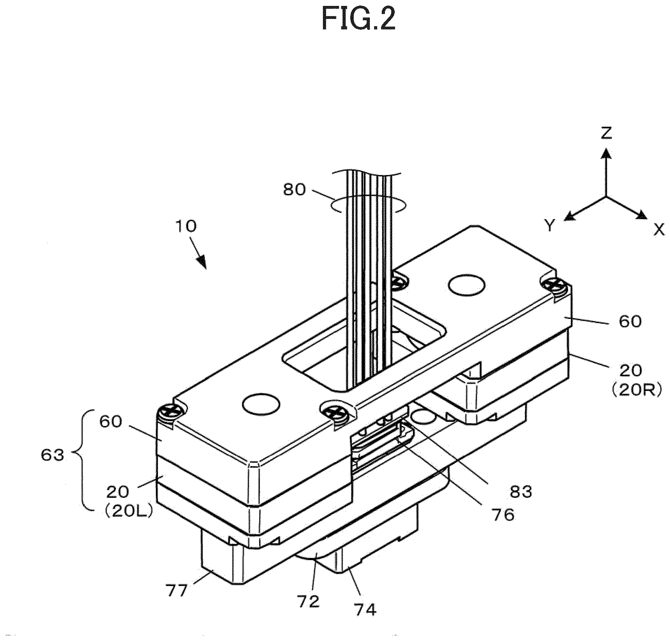

FIG. 2 is a perspective external appearance view illustrating the configuration example of the connector inspection jig 10 and is an external appearance view as viewed down from an obliquely upper side.

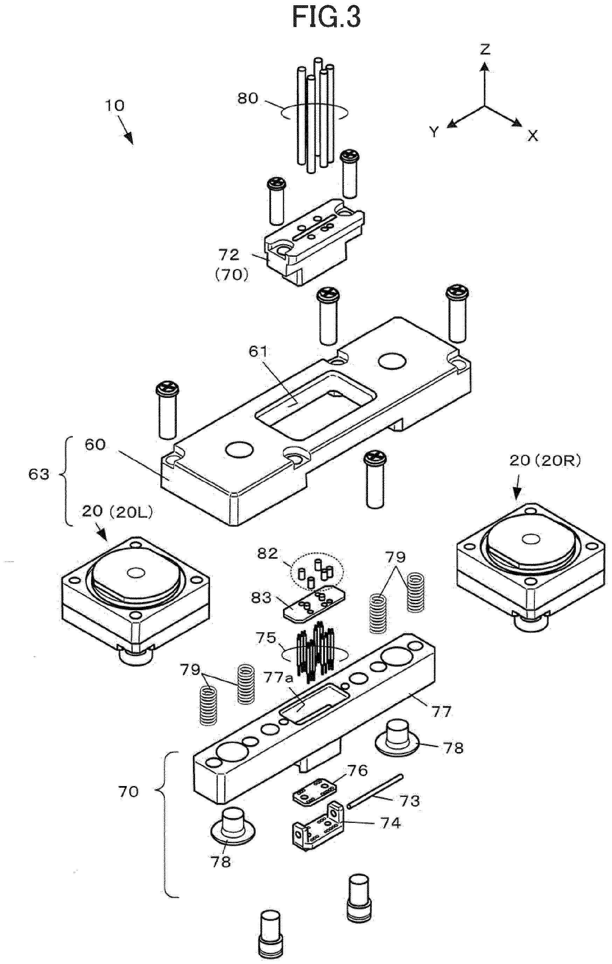

FIG. 3 is an exploded view of the connector inspection jig 10.

The connector inspection jig 10 in the present embodiment is a jig for connecting probes 75 with a substrate connector (a connector on an inspected side) mounted on a substrate as an inspection target by moving like descending from above from a Z-axis positive direction to a Z-axis negative direction that are illustrated in FIGS. 1 to 3. The probes 75 include signal measurement probes and grounding probes.

The connector inspection jig 10 has inspection jig support tools 20, a jig base 60, an inspection head body 70, and conductor bodies 80. The connector inspection jig 10 supports the inspection head body 70 by the inspection jig support tools 20.

The jig base 60 fixes two inspection jig support tools 20 at a space 61.

The inspection head body 70 is a supported object that is supported by the two inspection jig support tools 20. The inspection head body 70 has a conductor holder 72, a probe support portion 74, the probes 75, an electrically conductive probe guide plate 76, and a head base 77.

The probe support portion 74 is electrically non-conductive and is fixed to a lower end of a central portion of the head base 77 via the probe guide plate 76 by a fixing pin 73. Insertion holes for the probes 75 are made in the probe support portion 74. The probe support portion 74 causes lower portions of the probes 75 to be inserted through the insertion holes and thereby retains a relative position of each of the probes 75. A lower end of the probe 75 becomes a state where it passes through the insertion hole and protrudes on an inspection surface side as a lower surface (a surface on the Z-axis negative direction side) of the probe support portion 74. In an inspection, the probe support portion 74 is fitted on the connector on the inspected side and thereby guides the probes 75 to electrodes of the connector on the inspected side.

The probe guide plate 76 is electrically conductive, guides the probes 75 to the probe support portion 74, and retains relative positions among the probes 75. The probe guide plate 76 functions as a spacer for extending the head base 77 and adjusts the heights of the grounding probes in the probes 75.

The head base 77 has a gap in an insertion portion 77a at a center, through which the conductor holder 72 is inserted, and thereby retains the conductor holder 72.

The conductor bodies 80 are electrical wires whose electrically conductive core wires are covered and electrically connect the inspection head body 70 with an inspection device body not illustrated. The conductor bodies 80 are retained and guided in a state where mutual relative positions are maintained by the conductor holder 72, and lower ends of those are connected with the probes 75 via coaxial insulators 82 and a coaxial guide 83. The conductor body 80 is drawn out from a back surface side of the probe 75. The back surface side of the probe 75 is the opposite side to the inspection surface side on which the lower end of the probe 75 protrudes. It may be considered that the conductor body 80 is drawn out along the longitudinal direction of the probe 75.

The coaxial insulator 82 is a member for keeping impedance and serves to keep a coaxial condition between the probe 75 and the conductor body 80.

The head base 77 is a straight member in which the conductor holder 72 is inserted through and supported by the insertion portion 77a at the center. The head base 77 is coupled with the inspection jig support tool 20 by a fixing bolt 78 in each of both end portions.

The two inspection jig support tools 20 are coupled with an upper surface (a surface on a Z-axis positive direction side) of the head base 77 via respective floating springs 79. It may be considered that the head base 77 is suspended from the two inspection jig support tools 20.

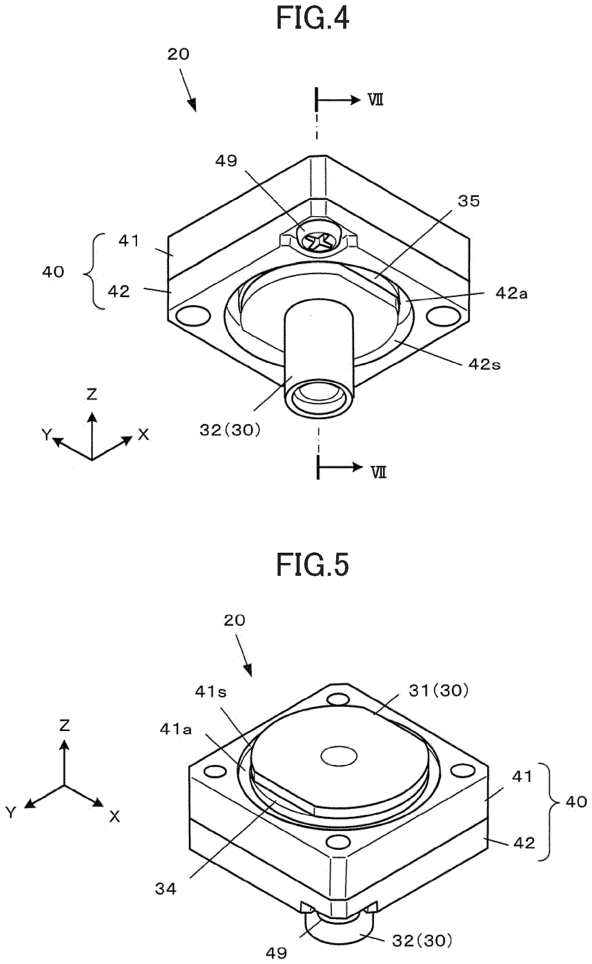

FIG. 4 is a perspective external appearance view illustrating a configuration example of the inspection jig support tool 20 in the present embodiment and is an external appearance view as viewed up from an obliquely lower side.

FIG. 5 is a perspective external appearance view illustrating the configuration example of the inspection jig support tool 20 and is an external appearance view as viewed down from an obliquely upper side.

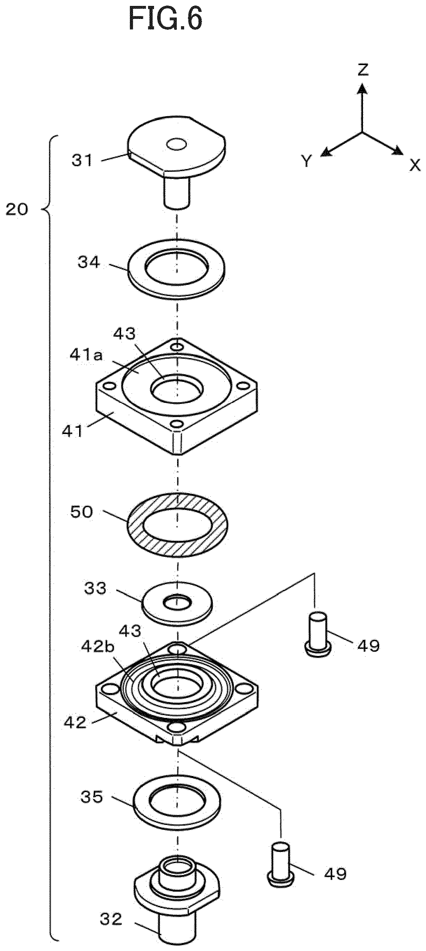

FIG. 6 is an exploded view of the inspection jig support tool 20.

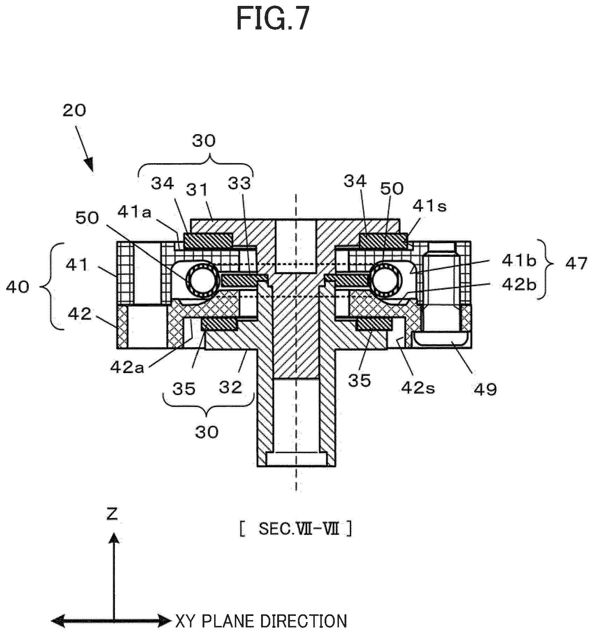

FIG. 7 is a vertical cross-sectional view of the inspection jig support tool 20.

The inspection jig support tool 20 is a mechanical portion that has a floating structure tolerating relative displacement in a direction intersecting with a supporting direction (a vertical direction in the present embodiment: a Z-axis direction in FIGS. 4 to 7) while retaining a supported posture of a supported object.

The inspection jig support tool 20 has a coupling axis portion 30 to be coupled with a supported object (in the present embodiment, the inspection head body 70), an annular coil spring 50, and a base portion 40 in which the annular coil spring 50 is built and that supports the coupling axis portion 30.

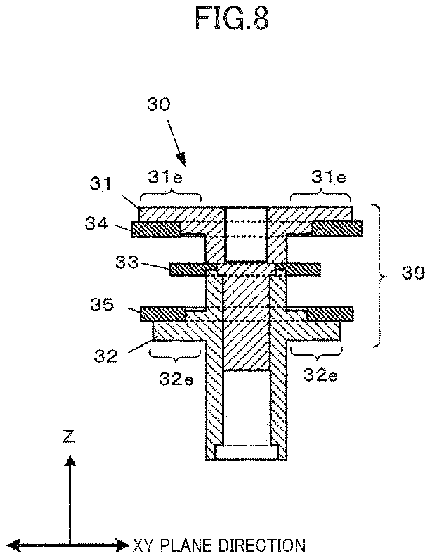

FIG. 8 is a vertical cross-sectional view of the coupling axis portion 30.

The coupling axis portion 30 is a structure body having plural flange-shaped extended portions around a shaft from which the supported object is suspended. The coupling axis portion 30 has a first friction reduction ring 34, a second friction reduction ring 35, and an axis-side fitting portion 39. The axis-side fitting portion 39 has a mount shaft 31, a connection shaft 32, and a slide washer 33. The axis-side fitting portion 39 is fitted in the base portion 40 and the annular coil spring 50.

A lower end portion of the mount shaft 31 and an upper end portion of the connection shaft 32 are coupled together by screwing, press-fitting, or the like. The slide washer 33 is positioned such that it is held between the mount shaft 31 and the connection shaft 32.

The slide washer 33 is a flange portion in the axis-side fitting portion 39 and is a circularly annular metal plate, for example. The slide washer 33 protrudes outward in a radial direction from an outer peripheral surface of the axis-side fitting portion 39 and touches an inner peripheral surface of the annular coil spring 50.

The mount shaft 31 is a part of the axis-side fitting portion 39, the part being positioned relatively high in the present embodiment, and has a flange-shaped first extended portion 31e in an outer edge of an upper end portion thereof. The first friction reduction ring 34 is attached to an outer edge lower surface of the first extended portion 31e.

The first friction reduction ring 34 is made of a material that can reduce the friction coefficient compared to a case where the mount shaft 31 directly contacts with the base portion 40 by the first extended portion 31e. For example, the first friction reduction ring 34 is realized with a washer formed of a synthetic resin or metal.

The connection shaft 32 is a part of the axis-side fitting portion 39, the part being positioned relatively low in the present embodiment, and has a flange-shaped second extended portion 32e in a position close to the upper end portion. The second friction reduction ring 35 similar to the first friction reduction ring 34 is attached to an outer edge upper surface of the second extended portion 32e.

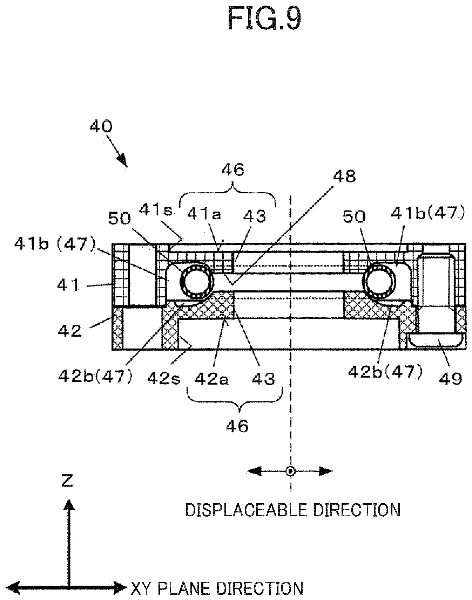

FIG. 9 is a vertical cross-sectional view of the base portion 40.

The base portion 40 is a member retaining the coupling axis portion 30 such that it is capable of being displaced in a radial direction of an axis and in an axial rotation direction. The base portion 40 is a member retaining the coupling axis portion 30 in a displaceable manner such that even when the axis of the coupling axis portion 30 is moved in an intersecting direction of the axis (the radial direction, in other words, an XY plane direction), a parallel or generally parallel state is maintained between the axis that is not yet moved and the axis that is already moved. The base portion 40 is a member retaining the coupling axis portion 30 in a displaceable manner such that the coupling axis portion 30 can be axially rotated. The base portion 40 has a first part 41 and a second part 42 that are coupled together by coupling screws 49 while abutting with each other in the vertical direction.

The first part 41 and the second part 42 have, in respective central portions, hole-side fitting portions 46 through which the axis-side fitting portion 39 of the coupling axis portion 30 is inserted and in which the axis-side fitting portion 39 is fitted with a gap.

The first part 41 has, on an upper surface side, a first recess portion 41a that is formed to be recessed downward to form a flat circular shape in a plane (an XY plane in FIG. 9) orthogonal to the supporting direction of the supported object, when viewed from above. The first extended portion 31e and the first friction reduction ring 34 of the coupling axis portion 30 are fitted with a gap such that the first friction reduction ring 34 touches a bottom surface of this first recess portion 41a. The first recess portion 41a functions as a support portion supporting the first extended portion 31e and the first friction reduction ring 34 of the coupling axis portion 30 such that those are capable of slide movement along a plane (an XY place in FIG. 9) orthogonal to the supporting direction of the supported object.

The top view radius of the first recess portion 41a is set larger than the top view radii of the first extended portion 31e and the first friction reduction ring 34 of the coupling axis portion 30. In a case where the displacement in an intersecting direction intersecting with the axis of the coupling axis portion 30 fitted in the base portion 40 reaches a predetermined maximum tolerated displacement amount, an inner peripheral side surface of the first recess portion 41a functions as a restriction portion 41s that the outer peripheral surface of the axis-side fitting portion 39 (in the present embodiment, an outer peripheral surface of the first friction reduction ring 34) touches.

The second part 42 has, on a lower surface side, a second recess portion 42a that is formed to be recessed upward to form a flat circular shape in a plane (an XY plane in FIG. 9) orthogonal to the supporting direction of the supported object, when viewed from below. The second extended portion 32e and the second friction reduction ring 35 of the coupling axis portion 30 are fitted with a gap such that the second friction reduction ring 35 touches a surface on a lower side as a ceiling of a recess portion of this second recess portion 42a. The second recess portion 42a functions as a support portion supporting the second extended portion 32e and the second friction reduction ring 35 of the coupling axis portion 30 such that those are capable of slide movement along a plane (an XY place in FIG. 9) orthogonal to the supporting direction of the supported object.

The bottom view radius of the second recess portion 42a is set larger than the bottom view radii of the second extended portion 32e and the second friction reduction ring 35 of the coupling axis portion 30. In a case where the displacement in an intersecting direction (that is the radial direction of the axis) intersecting with the axis of the coupling axis portion 30 fitted in the base portion 40 reaches a predetermined maximum tolerated displacement amount, an inner peripheral side surface of the second recess portion 42a functions as a restriction portion 42s that the outer peripheral surface of the axis-side fitting portion 39 (in the present embodiment, an outer peripheral surface of the second friction reduction ring 35) touches.

Focusing on a fitting relationship between the coupling axis portion 30 and the base portion 40, an inner peripheral surface of the first recess portion 41a, an insertion hole 43, and an inner peripheral surface of the second recess portion 42a become the hole-side fitting portions 46 that fit the axis-side fitting portion 39 with a gap.

The first recess portion 41a and the second recess portion 42a support the coupling axis portion 30 such that it is capable of sliding in a direction parallel with an XY plane (the radial direction) and restricts the coupling axis portion 30 such that it is not displaced in an axis direction of the coupling axis portion 30, by both of the first recess portion 41a and the second recess portion 42a. In other words, in the base portion 40, the hole-side fitting portions 46 are held between the two extended portions of the coupling axis portion 30, and movement of the coupling axis portion 30 in the axis direction is thereby restricted.

The first part 41 has, on a lower surface side, a first circularly annular recess portion 41b that is formed to be recessed upward while forming a circularly annular shape so as to maintain an edge of the insertion hole 43 through whose center the coupling axis portion 30 is inserted, when viewed from below. A connection portion between an inside surface of the first circularly annular recess portion 41b and a surface on a lower side as a ceiling of a recess portion of the first circularly annular recess portion 41b forms a slant face and a curved surface with a greater curvature than an outer periphery of the annular coil spring 50.

The second part 42 has, on an upper surface side, a second circularly annular recess portion 42b that is formed to be recessed downward while forming a circularly annular shape so as to maintain an edge of the insertion hole 43 through whose center the coupling axis portion 30 is inserted, when viewed from below. A connection portion between an inside surface of the second circularly annular recess portion 42b and a bottom surface forms a slant face and a curved surface with a greater curvature than the outer periphery of the annular coil spring 50.

The first part 41 and the second part 42 are combined together, the first circularly annular recess portion 41b and the second circularly annular recess portion 42b abut each other, and a space is thereby formed. This space functions as a spring retaining portion 47 that retains the annular coil spring 50 while tolerating deformation in an outward direction of an annular shape (deformation in a radius enlarging direction) but restraining deformation in an inward direction of the annular shape in a restored state (deformation in a radius shrinking direction). Viewing this in a different way, it may be considered that the spring retaining portion 47 retains the annular coil spring 50 such that it is capable of deforming in the radius enlarging direction to a predetermined maximum tolerated deformation amount.

The first part 41 and the second part 42 are combined together, and an annular groove portion 48 is thereby formed in an inner peripheral surface of the spring retaining portion 47. The slide washer 33 (flange portion) touches the inner peripheral surface of the annular coil spring 50 via this annular groove portion 48.

The annular coil spring 50 is a circularly annular member that is a coil spring configured in an annular shape. For example, the annular coil spring 50 can be made by bending an extension coil spring in a circularly annular shape and connecting both ends together.

An inner diameter of the annular coil spring 50 is set to agree with a diameter of an inside inner surface of the space of the spring retaining portion 47, and an annular inner surface of the annular coil spring 50 contacts with the inside inner surface of the space of the spring retaining portion 47.

An outer diameter of an annular shape of the annular coil spring 50 is set smaller than a diameter of an outside inner surface of the space of the spring retaining portion 47. A clearance between both of those is set to become larger than a tolerance amount for relative displacement of the coupling axis portion 30 towards the base portion 40.

An outer diameter of a coil of the annular coil spring 50 (corresponding to an outer diameter in a Z-axis direction in FIG. 9) is set smaller than a thickness of the space of the spring retaining portion 47 in a perpendicular direction (the Z-axis direction in FIG. 9).

In a no-load state for the annular coil spring 50 as a state where a supported object is not coupled with the inspection jig support tool 20, the annular coil spring 50 is retained along the inside inner surface of the space of the spring retaining portion 47 in a state where slight tension is generated.

The annular coil spring 50 has a fastening force by which the axis of the coupling axis portion 30 is capable of returning to a reference position in a no-load condition. Because the slide washer 33 touches an inner periphery of the annular shape of the annular coil spring 50, for a central axis of the slide washer 33 (the same as the axis of the shaft of the coupling axis portion 30), a position on a central axis or a generally central axis of the annular shape of the annular coil spring 50 becomes the reference position. In the no-load condition in which an external force causing deformation does not act on the annular coil spring 50, the fastening force of the annular coil spring 50 acts on the coupling axis portion 30 via the slide washer 33, and the coupling axis portion 30 is restored to the reference position (the state in FIG. 7).

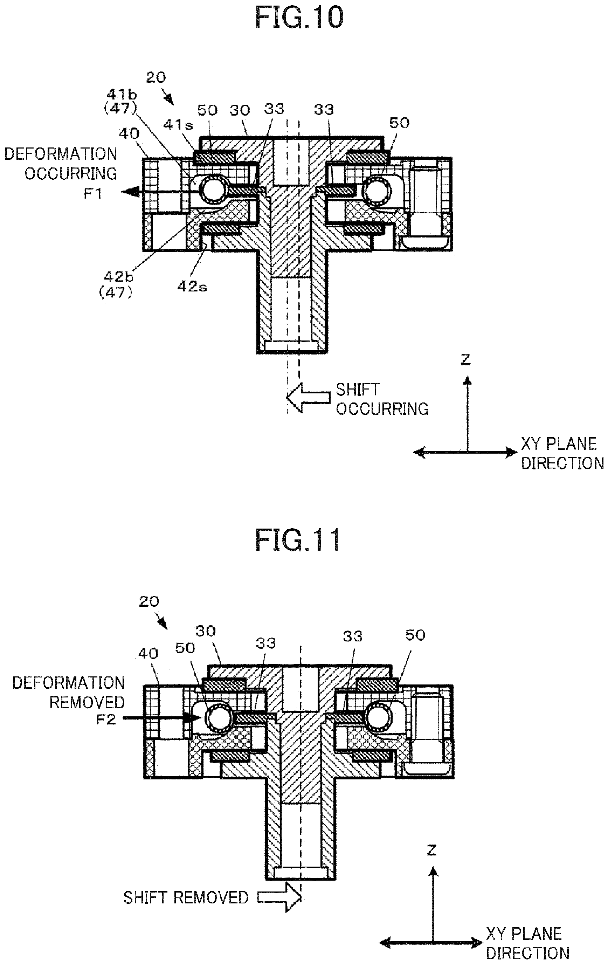

FIG. 10 and FIG. 11 are diagrams for explaining an action implemented by the inspection jig support tool 20.

FIG. 10 illustrates a state where a factor of displacement of the coupling axis portion 30 from the reference position occurs. "Factor of displacement" mentioned here denotes a state where position deviation between the connector on the inspected side and the inspection jig occurs, in the present embodiment. This position deviation amount is absorbed by a shift (displacement) of the coupling axis portion 30 towards the base portion 40.

In the example of FIG. 10, the coupling axis portion 30 is displaced in a left direction in FIG. 10, a left side portion in FIG. 10 in an annular-shape inside surface of the annular coil spring 50 is pushed by the slide washer 33 (an acting force F1 in FIG. 10), and the annular coil spring 50 deforms to extend in the left direction in FIG. 10. Further, a diameter of the coil spring configuring the annular coil spring 50 is smaller than a height of the space of the spring retaining portion 47 in the vertical direction. Thus, a portion deformed in the left direction in FIG. 10 in the annular coil spring 50 deforms to move to an upper side or a lower side in FIG. 10. FIG. 10 illustrates a state where the annular coil spring 50 moves to the upper side and contacts with an upper side of the space of the spring retaining portion 47. Because the annular coil spring 50 is pushed by the slide washer 33, the annular coil spring 50 is in a state of contacting with the slide washer 33 also. Because the annular coil spring 50 is deformed in a state where it contacts with the upper side or a lower side of the space of the spring retaining portion 47 and the slide washer 33, although being in a deformed shape, the deformed shape is in a stable state. This also means that a restoring force of the annular coil spring 50 is stably acting.

FIG. 11 illustrates a circumstance in which the factor of displacement has already been removed. In the present embodiment, this means that FIG. 11 illustrates a circumstance in which an inspection is finished, the inspection jig is separated from the connector on the inspected side, and connection is released. When the factor of displacement is removed, the slide washer 33 is urged in a right direction in FIG. 11 by the restoring force of the annular coil spring 50 (an acting force F2 in FIG. 11), and the coupling axis portion 30 is returned to the reference position. When the coupling axis portion 30 reaches the reference position, because the annular coil spring 50 returns to an original annular shape, and the restoring force also stops acting.

A support tool 63 acts to support the inspection head body 70 such that it is capable of being displaced in a predetermined two-dimensional displaceable range and in a predetermined rotatable angle range. The support tool 63 has a first inspection jig support tool 20R, a second inspection jig support tool 20L, and the jig base 60. The first inspection jig support tool 20R and the second inspection jig support tool 20L are the inspection jig support tools 20. The first inspection jig support tool 20 (20R) and the second inspection jig support tool 20 (20L) are arranged by the jig base 60 such that their respective supporting directions become parallel with the axis of the coupling axis portion 30.

Depending on an touching positional relationship between the slide washer 33 and the annular coil spring 50, there may be a case where the annular coil spring 50 gets away to a lower side than a position illustrated in FIG. 10 and the annular coil spring 50 becomes a state of being pressed to the bottom surface of the second circularly annular recess portion 42b. Even in such a state, because the restoring force urges the slide washer 33, the coupling axis portion 30 can similarly be returned to the reference position.

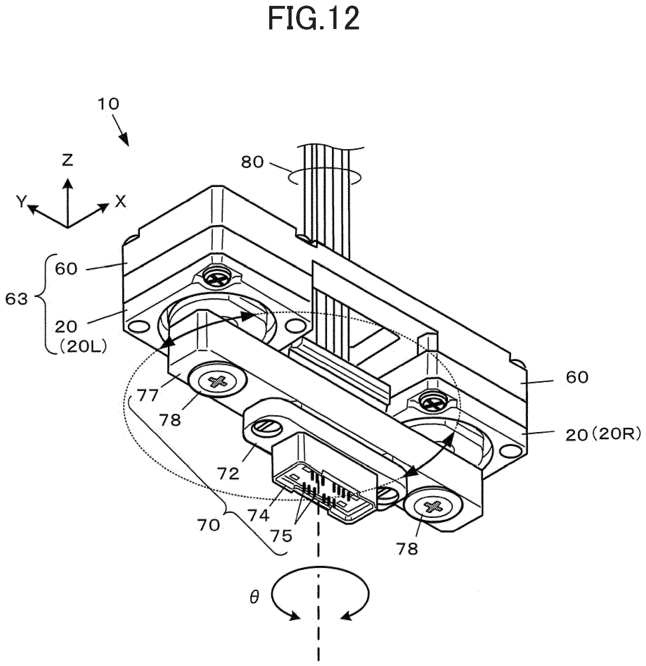

FIG. 12 is a diagram for explaining tolerance for deviation of the inspection head body 70 in an axial rotation direction, the tolerance being realized by the two inspection jig support tools 20.

Both end portions of the inspection head body 70 are respectively supported by the coupling axis portions 30. Thus, even when rotation θ around a perpendicular axis (the Z-axis in FIG. 12) (rotation around the perpendicular axis as viewed from the inspection head body 70) occurs to the inspection head body 70 when the probe support portion 74 is connected with the connector on the inspected side, the two coupling axis portions 30 are displaced in mutually opposite directions around the perpendicular axis direction along a horizontal plane (a direction parallel with an XY plane in FIG. 12), and deviation due to the rotation θ is thereby tolerated. When connection for an inspection is released, because the two inspection jig support tools 20 cause an action for returning the respective coupling axis portions 30 to the reference positions, deviation due to the rotation θ is also removed.

As described above, the inspection jig support tools 20 of the connector inspection jig 10 of the present embodiment can tolerate position deviation between the connector inspection jig 10 and the connector on the inspected side and can also inhibit a change in relative positions of both of those, the change accompanying the tolerance for the position deviation. Thus, in a process in which the connector inspection jig 10 is connected with the connector on the inspected side, a position is automatically adjusted such that connection can be made in an appropriate position. When the connection between connectors is released after the inspection has been done, the connector inspection jig 10 automatically returns to an original condition.

In a process in which position deviation is adjusted, the probe support portion 74 of the connector inspection jig 10 is hardly inclined. Consequently, the possibility is low that the probes 75 installed in the jig obliquely contact with the electrodes of the connector on the inspected side, and the possibility can be lowered that the lives of the probes 75 are shortened by causing an unnecessary lateral load to act on the probes 75.

Because position deviation is tolerated in each direction in 360 degrees around the perpendicular axis, response capability to position deviation is excellent.

Because the annular coil spring 50 is employed as an element for applying the restoring force to the displaced coupling axis portion 30, responsiveness to displacement and durability are excellent compared to a case where an O-ring formed of a resin is used.

### Second embodiment

Next, a second embodiment will be described. In the following, a description will mainly be made about differences from the first embodiment, the same reference characters as the first embodiment are given to similar configuration elements to the first embodiment, and descriptions thereof will not be repeated.

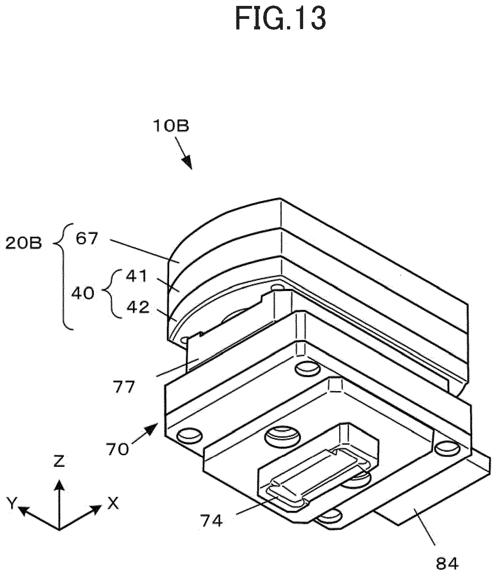

FIG. 13 is a perspective external appearance view illustrating a configuration example of a connector inspection jig 10B in the second embodiment and is an external appearance view as viewed up from an obliquely lower side.

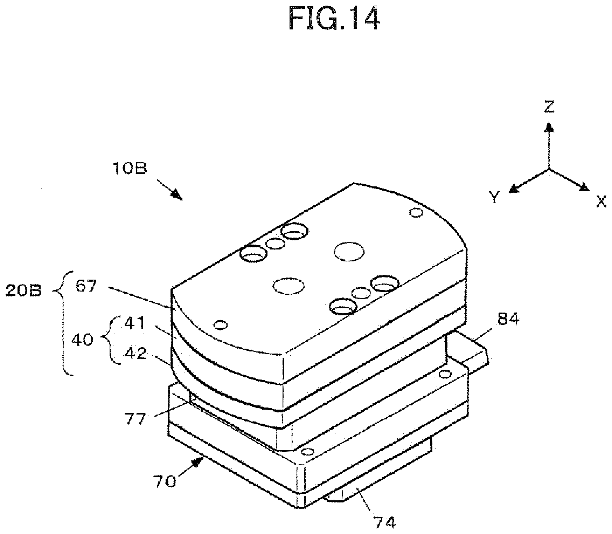

FIG. 14 is a perspective external appearance view illustrating the configuration example of the connector inspection jig 10B and is an external appearance view as viewed down from an obliquely upper side.

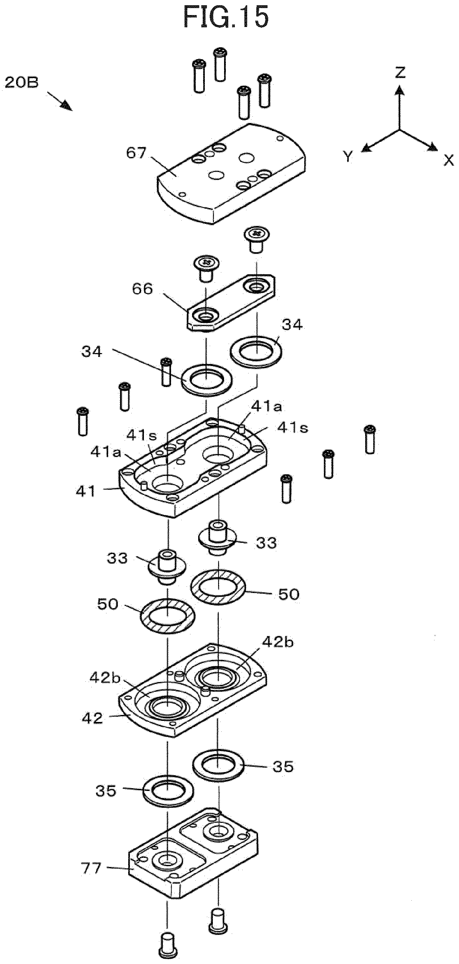

FIG. 15 is an exploded view of an inspection jig support tool 20B.

Comparing the present embodiment with the first embodiment, in the first embodiment, the two inspection jig support tools 20 are individually prepared as separate bodies and are connected by the jig base 60 (see FIG. 1 to FIG. 3), but the connector inspection jig 10B of the second embodiment is different in the point that two inspection jig support tools 20B share the base portion 40 and are integrally configured.

The present embodiment is different from the first embodiment in the point that the coupling axis portions 30 of the two inspection jig support tools 20 are caused to become a coupled state by a connection piece 66 and the two coupling axis portions 30 are configured to integrally perform relative displacement towards the base portion 40. The connector inspection jig 10B has a cover portion 67 that covers the connection piece 66.

The first embodiment has a configuration in which a conductor electrically connecting the inspection head body 70 and the inspection device body passes through a middle portion between the two inspection jig support tools 20, but the present embodiment is different in the point that an output connector 84 is attached to a side surface of the inspection head body 70 and connection is made with the inspection device body via the output connector 84.

### Third embodiment

Next, a third embodiment will be described. In the following, a description will mainly be made about differences from the first embodiment, the same reference characters as the first embodiment are given to similar configuration elements to the first embodiment, and descriptions thereof will not be repeated.

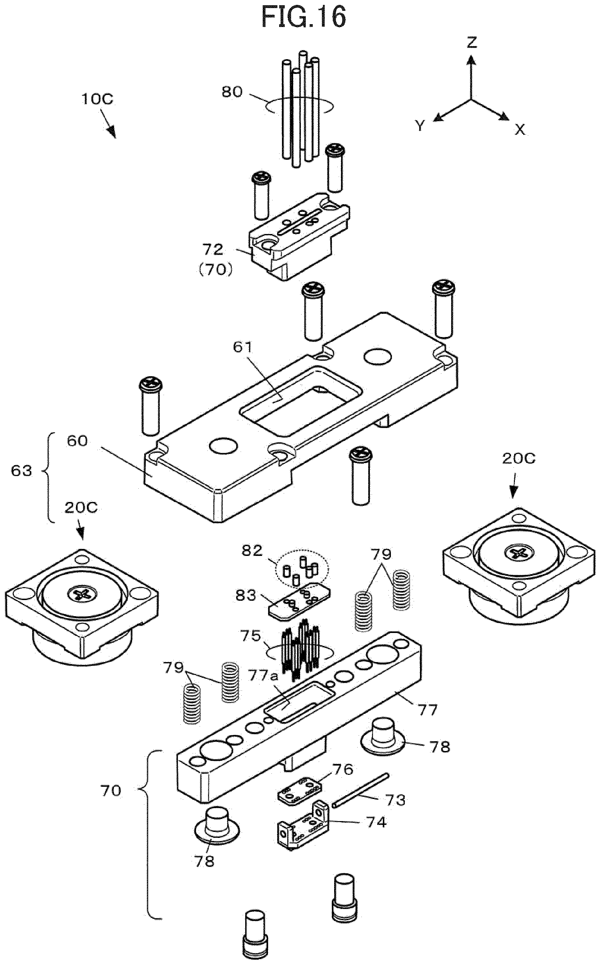

FIG. 16 is an exploded view of a connector inspection jig 10C in the present embodiment.

Comparing the present embodiment with the first embodiment, inspection jig support tools 20C included in the connector inspection jig 10C of the present embodiment are different in configuration from those of the first embodiment. The other elements than those are similar to the first embodiment.

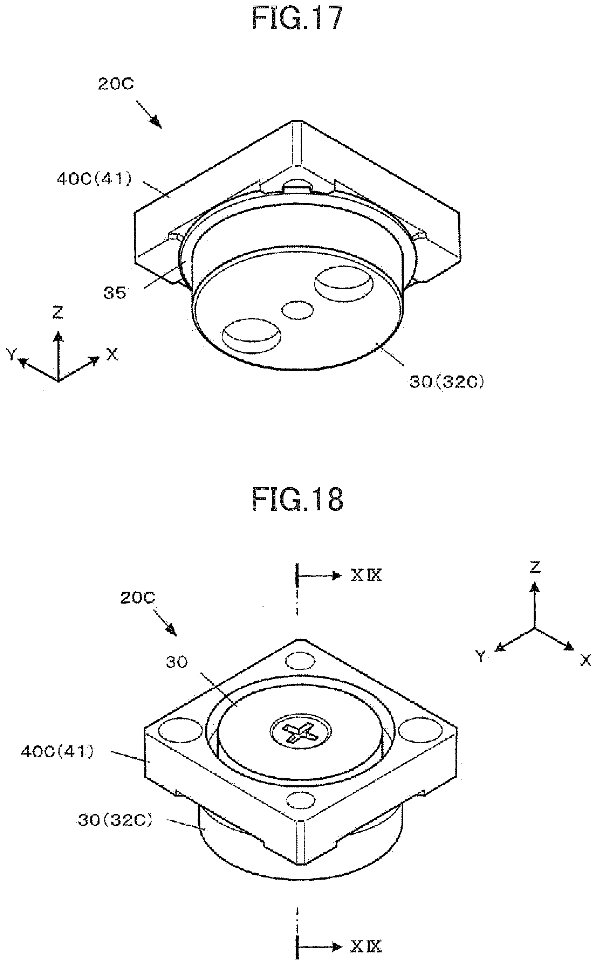

FIG. 17 is a perspective external appearance view illustrating a configuration example of the inspection jig support tool 20C in the present embodiment and is an external appearance view as viewed up from an obliquely lower side.

FIG. 18 is a perspective external appearance view illustrating the configuration example of the inspection jig support tool 20C and is an external appearance view as viewed down from an obliquely upper side.

When the inspection jig support tool 20C of the present embodiment is compared with the inspection jig support tool 20 of the first embodiment, a connection shaft 32C of the present embodiment serves as both of the second part 42 of the base portion 40 in the first embodiment and the connection shaft 32 in the first embodiment.

A base portion 40C of the present embodiment is configured with one component that corresponds to the first part 41 of the first embodiment and has a stepped recess portion 85 in its lower surface.

The stepped recess portion 85 has a slant portion 85s around the insertion hole 43. A surface that is on the outside of the slant portion 85s and on the inside of the second friction reduction ring 35 in a surface on a lower side as a ceiling of a recess portion of the stepped recess portion 85 becomes continuous with a lower surface of the attached second friction reduction ring 35 and forms a flat surface to an outer periphery of the base portion 40C. The surface corresponds to the first circularly annular recess portion 41b of the first embodiment. In other words, the surface forms a surface that an upper surface of the annular coil spring 50 touches.

Because the connection shaft 32C of the present embodiment is in sliding contact with the surface on the lower side as the ceiling of the recess portion of the stepped recess portion 85, the second friction reduction ring 35 is attached to the surface on the lower side.

Because the connection shaft 32C of the present embodiment serves as both of the second part 42 of the base portion 40 in the first embodiment and the connection shaft 32 in the first embodiment, the second circularly annular recess portion 42b is formed to be recessed in an upper surface of the connection shaft 32C of the present embodiment.

In the inspection jig support tool 20C of the present embodiment, a limit of relative displacement of the coupling axis portion 30 is defined by a clearance between an inner peripheral surface of the insertion hole 43 made at a center of the base portion 40 and the connection shaft 32C.

The inspection jig support tool 20C of the present embodiment can reduce the number of components compared to that of the first embodiment, cost reduction and size reduction can be intended compared to the first embodiment while similar actions and effects are realized.

In the above, some embodiments to which the invention is applied are described. However, forms to which the invention is applicable are not limited to the above forms, but appropriate addition, omission, alterations of configuration elements may be conducted.

For example, in the first embodiment, an example is described where the connector inspection jig 10 includes the support tool 63 and the support tool 63 has the two inspection jig support tools 20 (the first inspection jig support tool 20R and the second inspection jig support tool 20L) (see FIG. 1 and FIG. 2). However, the support tool 63 may have three or more inspection jig support tools 20.

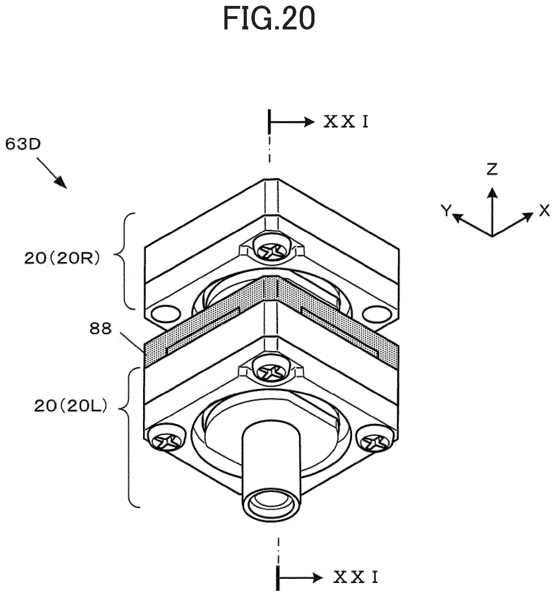

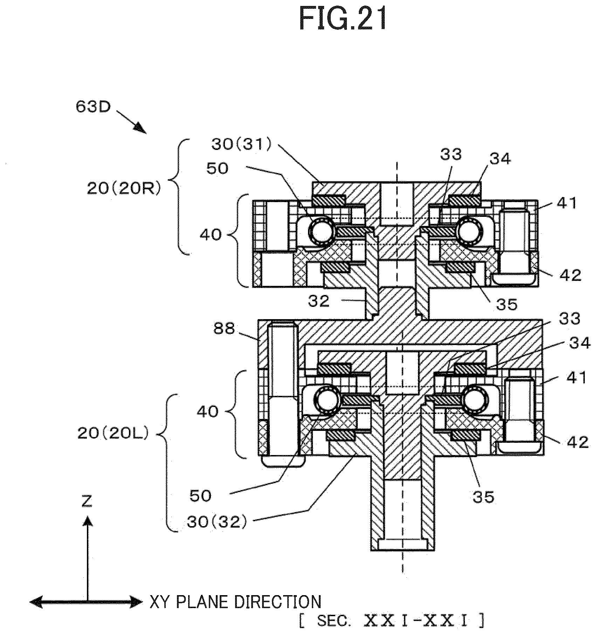

In the above embodiment, a configuration is raised, as an example, in which the two inspection jig support tools 20 (the first inspection jig support tool 20R and the second inspection jig support tool 20L) are plurally arranged in a direction intersecting with the axis direction of the coupling axis portion 30; however, the arrangement relationship between the two inspection jig support tools 20 (the first inspection jig support tool 20R and the second inspection jig support tool 20L) is not limited to this example. For example, as illustrated in FIG. 20 and FIG. 21, a linking part 88 is fixed to the first part 41 of one of the two inspection jig support tools 20 (20R and 20L), the linking part 88 is connected with the connection shaft 32 of the coupling axis portion 30 of the other, and an integral support tool 63D may thereby be formed in which the inspection jig support tools 20 are multiply connected in the axis direction of the coupling axis portion 30. The inspection jig support tools 20 of the first embodiment are capable of being replaced by the support tool 63D. By replacement, an advantage of tolerating larger position deviation can be obtained.

In addition, in the example of FIG. 20 and FIG. 21, plural inspection jig support tools 20 (20R and 20L) are linked together such that the axis directions of the coupling axis portions 30 become the same direction; however, a configuration is possible in which the integral support tool 63 is formed by linking those such that the axis directions of the coupling axis portions 30 become different directions (for example, to be orthogonal).

In the above embodiment, the connector inspection jig 10 is described as being connected with an inspection target from above; however, the connector inspection jig 10 may be used in a form of being connected with an inspection target from below or may be used in a form of being connected from a lateral side.

The disclosure described above may be summarized as follows.

A first aspect of the present disclosure provides an inspection jig support tool including: a coupling axis portion having an axis-side fitting portion and being coupled with an inspection head body; an annular coil spring being arranged in an outer periphery of the axis-side fitting portion; and a base portion retaining the coupling axis portion such that the coupling axis portion is capable of being displaced in a radial direction of an axis and in an axial rotation direction, in which the base portion has: a spring retaining portion retaining the annular coil spring while tolerating deformation of the annular coil spring in a radius enlarging direction; and a hole-side fitting portion being fitted on the axis-side fitting portion with a gap.

In the first aspect, the coupling axis portion coupled with the inspection head body is retained such that displacement in the radial direction of the axis and in the axial rotation direction towards the base portion is possible. Furthermore, as for the coupling axis portion, the axis-side fitting portion is fitted in the hole-side fitting portion with a gap. Consequently, even when mounting positions of connectors on the inspected side are non-uniform, the coupling axis portion is displaced in the radial direction of the axis and in the axial rotation direction towards the base portion, and the inspection head body can thereby quickly move to an appropriate connection position for the connector on the inspected side. Thus, tolerance for and responsiveness to position deviation are excellent.

The annular coil spring may have a fastening force by which the axis of the coupling axis portion is capable of returning to a reference position in a no-load condition.

In the no-load condition, the fastening force of the annular coil spring acts, and the coupling axis portion is restored to the reference position.

The axis-side fitting portion may have a flange portion that protrudes outward in the radial direction from an outer peripheral surface and touches an inner peripheral surface of the annular coil spring, and the hole-side fitting portion may have a restriction portion that the outer peripheral surface touches in a case where displacement of the coupling axis portion in the radial direction reaches a predetermined maximum tolerated displacement amount.

The flange portion protrudes outward in the radial direction from the outer peripheral surface of the axis-side fitting portion and touches the inner peripheral surface of the annular coil spring. Because the outer peripheral surface of the axis-side fitting portion touches the restriction portion in a case where displacement of the coupling axis portion in the radial direction reaches the predetermined maximum tolerated displacement amount, the restriction portion can restricts displacement of the coupling axis portion.

The spring retaining portion may retain the annular coil spring such that the annular coil spring is capable of deforming in the radius enlarging direction to a predetermined maximum tolerated deformation amount, and the maximum tolerated displacement amount may be smaller than the maximum tolerated deformation amount.

The spring retaining portion may have an annular groove portion, and the flange portion may touch the inner peripheral surface of the annular coil spring via the annular groove portion.

The axis-side fitting portion may have two extended portions and may hold the hole-side fitting portion between the two extended portions.

The hole-side fitting portion is held between the two extended portions of the coupling axis portion, and movement of the coupling axis portion in the axis direction is thereby restricted in the base portion.

A second aspect provides a support tool including a first inspection jig support tool and a second inspection jig support tool according to the first aspect, in which the first inspection jig support tool and the second inspection jig support tool are arranged while the coupling axis portion of the first inspection jig support tool and the coupling axis portion of the second inspection jig support tool are in parallel with each other and the first inspection jig support tool and the second inspection jig support tool support the inspection head body such that the inspection head body is capable of being displaced in a predetermined range.

In the second aspect, tolerance for and responsiveness to position deviation are excellent.

The support tool may further include a jig base supporting the inspection head body, in which the first inspection jig support tool may support one end side of the jig base and the second inspection jig support tool may support another end side of the jig base.

A third aspect provides an inspection jig including: the inspection head body; and the support tool according to the second aspect that supports the inspection head body.

In the third aspect, tolerance for and responsiveness to position deviation are excellent.

A fourth aspect provides an inspection jig including: the inspection head body; and the support tool according to the second aspect that supports the inspection head body, in which in the inspection head body, plural probes to contact with an inspected object protrude on an inspection surface side, electrical wires of the probes are drawn out from a back surface on an opposite side to the inspection surface, and the jig base supports the inspection head body in a central portion.

In the fourth aspect, tolerance for and responsiveness to position deviation are excellent.

A fifth aspect provides a support tool including a first inspection jig support tool and a second inspection jig support tool according to the first aspect, in which the base portion of the first inspection jig support tool is coupled with the coupling axis portion of the second inspection jig support tool.

In the fifth aspect, tolerance for and responsiveness to position deviation are excellent. In addition, the two inspection jig support tools are configured as an integral support tool, and the inspection head body can thereby be supported so as to be capable of being displaced in a predetermined range.

### Explanation of References

- 10, 10B, 10C: connector inspection jig
- 20, 20B, 20C: inspection jig support tool
- 20R: first inspection jig support tool
- 20L: second inspection jig support tool
- 30: coupling axis portion
- 31: mount shaft
- 31e: first extended portion
- 32, 32C: connection shaft
- 32e: second extended portion
- 33: slide washer
- 34: first friction reduction ring
- 35: second friction reduction ring
- 39: axis-side fitting portion
- 40, 40C: base portion
- 41: first part
- 41a: first recess portion
- 41b: first circularly annular recess portion
- 41s: restriction portion
- 42: second part
- 42a: second recess portion
- 42b: second circularly annular recess portion
- 42s: restriction portion
- 43: insertion hole
- 46: hole-side fitting portion
- 47: spring retaining portion
- 48: annular groove portion
- 50: annular coil spring
- 60: jig base
- 61: space
- 63, 63D: support tool
- 70: inspection head body
- 74: probe support portion
- 75: probe
- 77: head base
- 80: conductor body
- 84: output connector
- 85: stepped recess portion
- θ: rotation (rotation around fixed axis)

## Claims

1. An inspection jig support tool comprising:
a coupling axis portion having an axis-side fitting portion and being coupled with an inspection head body;
an annular coil spring being arranged in an outer periphery of the axis-side fitting portion; and
a base portion retaining the coupling axis portion such that the coupling axis portion is capable of being displaced in a radial direction of an axis and in an axial rotation direction,
wherein
the base portion has:
a spring retaining portion retaining the annular coil spring while tolerating deformation of the annular coil spring in a radius enlarging direction; and
a hole-side fitting portion being fitted on the axis-side fitting portion with a gap.

2. The inspection jig support tool according to claim 1, wherein
the annular coil spring has a fastening force by which the axis of the coupling axis portion is capable of returning to a reference position in a no-load condition.

3. The inspection jig support tool according to claim 2, wherein
the axis-side fitting portion has a flange portion that protrudes outward in the radial direction from an outer peripheral surface and touches an inner peripheral surface of the annular coil spring, and
the hole-side fitting portion has a restriction portion that the outer peripheral surface touches in a case where displacement of the coupling axis portion in the radial direction reaches a predetermined maximum tolerated displacement amount.

4. The inspection jig support tool according to claim 3, wherein
the spring retaining portion retains the annular coil spring such that the annular coil spring is capable of deforming in the radius enlarging direction to a predetermined maximum tolerated deformation amount, and
the maximum tolerated displacement amount is smaller than the maximum tolerated deformation amount.

5. The inspection jig support tool according to claim 3 or 4, wherein
the spring retaining portion has an annular groove portion, and
the flange portion touches the inner peripheral surface of the annular coil spring via the annular groove portion.

6. The inspection jig support tool according to any one of claims 3 to 5, wherein
the axis-side fitting portion has two extended portions and holds the hole-side fitting portion between the two extended portions.

7. A support tool comprising
a first inspection jig support tool and a second inspection jig support tool according to any one of claims 1 to 6, wherein
the first inspection jig support tool and the second inspection jig support tool are arranged while the coupling axis portion of the first inspection jig support tool and the coupling axis portion of the second inspection jig support tool are in parallel with each other, and
the first inspection jig support tool and the second inspection jig support tool support the inspection head body such that the inspection head body is capable of being displaced in a predetermined range.

8. The support tool according to claim 7, further comprising
a jig base supporting the inspection head body, wherein
the first inspection jig support tool supports one end side of the jig base, and
the second inspection jig support tool supports another end side of the jig base.

9. An inspection jig comprising:
the inspection head body; and
the support tool according to claim 7 or 8 that supports the inspection head body.

10. An inspection jig comprising:
the inspection head body; and
the support tool according to claim 8 that supports the inspection head body, wherein
in the inspection head body, plural probes to contact with an inspected object protrude on an inspection surface side, electrical wires of the probes are drawn out from a back surface on an opposite side to the inspection surface, and
the jig base supports the inspection head body in a central portion.

11. A support tool comprising
a first inspection jig support tool and a second inspection jig support tool according to any one of claims 1 to 6, wherein
the base portion of the first inspection jig support tool is coupled with the coupling axis portion of the second inspection jig support tool.
